# EUROPEAN PATENT APPLICATION

(11) **EP 4 779 325 A1**
(43) Date of publication of application: **22.07.2026**
(21) Application number: 25180473.8
(22) Date of filing: 03.06.2025
(51) Int. Cl.: G01R 15/20, G01R 15/22

(54) **NON-INTRUSIVE PASSIVE WIRELESS SELF-ENERGIZING QUANTUM CURRENT SENSOR**

(30) Priority: 15.01.2025 CN 202510059466
(71) Applicant: Southern Power Grid Sensing Technology (Guangdong) Co., Ltd, Shenzhen, Guangdong 518102 (CN)
(72) Inventor: GAO, Ximing, Shenzhen, Guangdong, 518102 (CN); LIU, Yuquan, Shenzhen, Guangdong, 518102 (CN); TIAN, Bing, Shenzhen, Guangdong, 518102 (CN); LUO, Wei, Shenzhen, Guangdong, 518102 (CN); ZHAO, Jiguang, Shenzhen, Guangdong, 518102 (CN); ZHAO, Liang, Shenzhen, Guangdong, 518102 (CN); LV, Qiancheng, Shenzhen, Guangdong, 518102 (CN); WANG, Guoli, Shenzhen, Guangdong, 518102 (CN); XU, Changbao, Shenzhen, Guangdong, 518102 (CN); CAI, Guoyuan, Shenzhen, Guangdong, 518102 (CN); XU, Zhenheng, Shenzhen, Guangdong, 518102 (CN); YIN, Xu, Shenzhen, Guangdong, 518102 (CN); ZHANG, Jiaming, Shenzhen, Guangdong, 518102 (CN); FENG, Dong, Shenzhen, Guangdong, 518102 (CN); XIN, Mingyong, Shenzhen, Guangdong, 518102 (CN); LUO, Baifeng, Shenzhen, Guangdong, 518102 (CN); JING, Maoheng, Shenzhen, Guangdong, 518102 (CN); LI, Chun, Shenzhen, Guangdong, 518102 (CN); YE, Zhenliang, Shenzhen, Guangdong, 518102 (CN)
(74) Representative: Hoffmann Eitle

(57) **Abstract**

The present invention relates to the field of sensor technology, particularly to a non-intrusive passive wireless self-energizing quantum current sensor comprising: a self-energizing module and a quantum current sensor module; the self-energizing module is configured to collect an environmental energy of an environment where a measured device is located, and convert the environmental energy into an electric energy, to supply power to the quantum current sensor module with the converted electric energy, wherein the environmental energy comprises at least one of an electric energy, an optical energy, or a magnetic energy; and the quantum current sensor module is configured to sense a current signal of the measured device when it is detected that the measured device generates a magnetic field.

## Description

### TECHNICAL FIELD

The present application relates to the field of sensor technology, and particularly to a non-intrusive passive wireless self-energizing quantum current sensor.

### BACKGROUND

With the profound transformation of the global energy structure, the future power grid will enter a new era of large-scale AC-DC hybrid connection. This transformation has raised more urgent demands for wide temperature ranges and high precision current sensors, and has become one of the key challenges to ensure the high reliability development of the power grid.

The conventional amperometers are limited in the application scope thereof due to the need for direct connection to the circuit loop.

However, the electromagnetic induction coils are used for non-contact measurement, which can avoid the above-mentioned problem, but only the current variation can be captured, and there exist shortcomings in the measurement of the constant direct current. Therefore, improvement is urgently required.

### SUMMARY

In view of this, in order to address the above technical problem, it is necessary to provide a non-intrusive passive wireless self-energizing quantum current sensor capable of improving the use convenience of the quantum current sensor.

A non-intrusive passive wireless self-energizing quantum current sensor is provided, including: a self-energizing module and a quantum current sensor module. The self-energizing module is configured to collect environmental energy of an environment in which a measured device is located, and convert the environmental energy into electric energy, to supply power to the quantum current sensor module with the converted electric energy, the environmental energy includes at least one of electric energy, optical energy, or magnetic energy; and the quantum current sensor module is configured to sense a current signal of the measured device when it is detected that the measured device generates a magnetic field.

In an embodiment, the quantum current sensor module includes a diamond nitrogen-vacancy (NV) center magnetic sensor probe, a laser device, a microlens, and a photoelectric conversion submodule; the diamond NV center magnetic sensor probe is configured to transmit a control instruction to the laser device when a magnetic field generated by the measured device is detected; the laser device is configured to generate a laser beam according to the control instruction; the microlens is configured to converge a laser beam onto the diamond NV center magnetic sensor probe, to excite the diamond NV center magnetic sensor probe to generate a fluorescence signal; the photoelectric conversion submodule is connected to the laser device and the diamond NV center magnetic sensor probe, and is configured to convert a reference laser beam emitted by the laser device and the fluorescence signal into a current signal of the measured device.

In an embodiment, the self-energizing module includes: a direct current (DC) voltage difference energy harvesting submodule, configured to collect electric energy on a DC transmission line in the environment in which the measured device is located; a laser energy harvesting submodule, configured to collect optical energy generated by the laser device in the environment in which the measured device is located, and convert the generated optical energy into electric energy; a current transformer energy harvesting submodule, configured to collect magnetic energy of a magnetic field generated by a substation and a conductor in the environment in which the measured device is located, and convert the magnetic energy of the magnetic field into electric energy; an energy storage submodule, connected to the DC voltage difference energy harvesting submodule, the laser energy harvesting submodule, and the current transformer energy harvesting submodule, and configured to store the electric energies obtained by the DC voltage difference energy harvesting submodule, the laser energy harvesting submodule, and the current transformer energy harvesting submodule.

In an embodiment, the current transformer energy harvesting submodule is configured to, when determining that a current value corresponding to the magnetic energy of the magnetic field falls within a first current range, perform energy harvesting in an intermittent energy harvesting mode; the current transformer energy harvesting submodule is configured to, when determining that the current value corresponding to the magnetic energy of the magnetic field falls within a second current range, perform the energy harvesting in a continuous energy harvesting mode; a maximum value of the first current range is less than a minimum value of the second current range.

In an embodiment, the energy storage submodule includes: a multistage lithium-ion supercapacitor, connected to the DC voltage difference energy harvesting submodule, the laser energy harvesting submodule, and the current transformer energy harvesting submodule, and configured to store the electric energies obtained by the DC voltage difference energy harvesting submodule, the laser energy harvesting submodule, and the current transformer energy harvesting submodule.

In an embodiment, the the laser device includes: a laser, configured to generate the laser beam according to the control instruction; a laser noise suppressor, configured to suppress a power noise generated by the laser during an operation of the laser.

In an embodiment, the quantum current sensor module further includes: a microwave generation and analysis submodule, connected to the diamond NV center magnetic sensor probe and the photoelectric conversion submodule, and configured to transmit an original microwave signal to the diamond NV center magnetic sensor probe, to allow the diamond NV center magnetic sensor probe to return a feedback microwave signal corresponding to the original microwave signal, and further configured to determine, according to the feedback microwave signal and a current signal output by the photoelectric conversion submodule, magnetic field information of the magnetic field generated by the measured device; a microwave radiation substructure, connected to the microwave generation and analysis submodule, and configured to reduce a transmission loss and a reflection of the original microwave signal.

In an embodiment, the diamond NV center magnetic sensor probe includes a diamond NV center and a microwave transmission antenna, the quantum current sensor module further includes a microwave modulation submodule configured to generate a microwave modulation submodule signal, and transmit the microwave modulation submodule signal to the diamond NV center through the microwave transmission antenna, to control a manipulation consistency of diamond ensemble NV centers through the microwave modulation submodule signal.

In an embodiment, the quantum current sensor module further includes a temperature calibration submodule configured to suppress a temperature drift of the microwave modulation submodule.

In an embodiment, the non-intrusive passive wireless self-energizing quantum current sensor further includes a shielding housing, wherein the self-energizing module and the quantum current sensor module are located within a cavity of the shielding housing.

In an embodiment, the shielding housing includes a conductive metal outer layer, a nanocrystalline soft magnetic inner layer, and an equipotential module.

In an embodiment, the electric energy on the DC transmission line in the environment in which the measured device is located is obtained by converting the magnetic energy, the electric energy, or the optical energy.

In an embodiment, the DC voltage difference energy harvesting submodule is constructed based on a DC transmission line voltage drop principle.

In an embodiment, the energy storage submodule further includes a voltage converter configured to adjust an output voltage of the multistage lithium-ion supercapacitor according to an operating voltage of the quantum current sensor module.

According to the above non-intrusive passive wireless self-energizing quantum current sensor, in the present invention, the self-energizing module is utilized to collect energy in an environment around the measured device, the self-energizing module can convert the environmental energy into the electric energy through an efficient energy conversion mechanism, in order to provide the quantum current sensor module with the required electric power. The self-energizing module enables the quantum current sensor to be independent of the external power supply and power cords. With the self-energizing technology, the sensor can operate independently in any place where the environmental energy is available for collection, the flexibility and convenience of the sensor usage are improved.

### BRIEF DESCRIPTION OF THE DRAWINGS

FIG. 1 is a schematic structural diagram of a quantum current sensor according to an embodiment.
FIG. 2 is a schematic structural diagram of a quantum current sensor according to another embodiment.
FIG. 3 is a schematic structural diagram of a shielding housing according to an embodiment.
FIG. 4 is a schematic structural diagram of a self-energizing module according to an embodiment.
FIG. 5 is a schematic structural diagram of an energy storage submodule according to an embodiment.
FIG. 6 is a schematic structural diagram of a quantum current sensor module according to an embodiment.
FIG. 7 is a schematic structural diagram of an MEMS quantum current sensitive component according to an embodiment.
FIG. 8 is a schematic structural diagram of a laser device according to an embodiment.
FIG. 9 is a schematic structural diagram of a high-integration ASIC component housing according to an embodiment.

### DETAILED DESCRIPTION

In order to make the purposes, technical solution, and advantages of the present invention clearer, the present invention will be elaborated with reference to the accompanying drawings and embodiments. It should be appreciated that the specific embodiments described herein are merely used for explaining the present invention, rather than limiting the present invention.

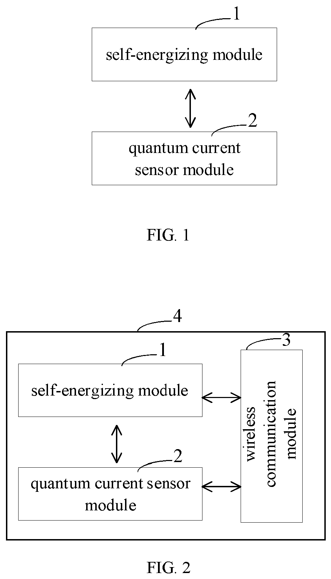

As shown in FIG. 1, in the embodiment, a non-intrusive passive wireless self-energizing quantum current sensor is provided. The quantum current sensor includes a self-energizing module 1 and a quantum current sensor module 2.

The self-energizing module 1 is configured to collect environmental energy of an environment in which a measured device is located, and convert the environmental energy into electric energy, to supply power to the quantum current sensor module with the converted electric energy.

The quantum current sensor module 2 is configured to sense a current signal of the measured device when it is detected that the measured device generates a magnetic field.

It should be appreciated that, a main function of the self-energizing module is to collect the environmental energy of the environment in which the measured device (for example, a conductor or a circuit board, etc.) is located, and convert the energy into electric energy. The purpose is to implement self-sufficiency of the sensor, that is, no external power supply is required.

The environmental energy may include at least one of electric energy, optical energy, or magnetic energy. This means that the sensor can be designed with a self-energizing manner according to the type of energy available in the actual application scenario. For example, in an environment with sufficient light, the optical energy may be selected as an energy source. In a scenario with a rich electromagnetic environment, the electric energy or magnetic energy may be selected. The converted electric energy is utilized to power the quantum current sensor module, thereby ensuring a normal operation of the entire sensor system.

A core task of the quantum current sensor module is to sense and measure a current signal of the measured device, which is implemented by detecting a magnetic field generated by the measured device. When a current flows through a conductor, a magnetic field is generated around the conductor. The quantum current sensor module can use this physical phenomenon to indirectly measure a magnitude and a direction of the current. The quantum current sensor module uses a quantum physical principle or technology to enhance the accuracy and sensitivity of the measurement. The design of the whole sensor is non-intrusive, which means that the sensor does not have direct physical contact with the measured device or change an operating status of the measured device, which helps to maintain the accuracy of the measurement and the safety of the measured device.

According to the aforementioned non-intrusive passive wireless self-energizing quantum current sensor, in the present invention, the self-energizing module is utilized to collect energy in an environment around the measured device, and the self-energizing module can convert the environmental energy into the electric energy through an efficient energy conversion mechanism, in order to provide the quantum current sensor module with the required electric power. The self-energizing module enables the quantum current sensor to be independent of the external power supply and power cords. With the self-energizing technology, the sensor can operate independently in any place where the environmental energy is available for collection, the flexibility and convenience of the sensor usage are improved.

In an exemplary embodiment, as shown in FIG. 2, a non-intrusive passive wireless self-energizing quantum current sensor further includes a wireless communication module 3 and a shielding housing 4.

It should be appreciated that, in the ultra-high voltage terminal current measurement, real-time performance and reliability of data are extremely important, because the stable operation of the electric power system requires accurate and timely current information for control and protection. In order to satisfy these requirements, the wireless communication module 3 in the embodiment uses a reliable radio frequency transmission technology based on an Wireless Networks for Industrial Automation (WIA) system. The WIA system is a wireless network standard designed for industrial environments, which provides communication capabilities with high reliability and low latency. In addition, a short-range wireless laser communication technology for electric power applications is further adopted. The laser communication has characteristics of good directionality and strong anti-interference capability, and is adapted to use in electric power systems with complex electromagnetic environments. A multi-mode complementary communication solution is implemented by combining the radio frequency and laser communication technologies.

In addition, according to an actual environment and a usage requirement, the wireless communication module 3 in the embodiment can flexibly select the most appropriate communication mode, to ensure the low latency and high reliability of the data transmission. The latency for point-to-point wireless communication is controlled to be less than or equal to 100 µ s, which meets the extremely high requirement for real-time performance of the ultra-high voltage terminal sensor. In the meanwhile, by optimizing a communication protocol and an error handling mechanism, over 99.999% of applications with high-reliablity requirementscan be realized. Accordingly, the problem of low-latency and high-reliability communication of the ultra-high voltage terminal sensor is effectively resolved.

It should be appreciated that, in an ultra-high voltage environment, electromagnetic interference is a serious problem. A strong electromagnetic field may interfere with the normal operation of the sensor, and even cause measurement errors or device damage. In order to resolve the problem, the shielding housing 4 in the embodiment can provide a physical barrier to prevent direct interference from an external electromagnetic field.

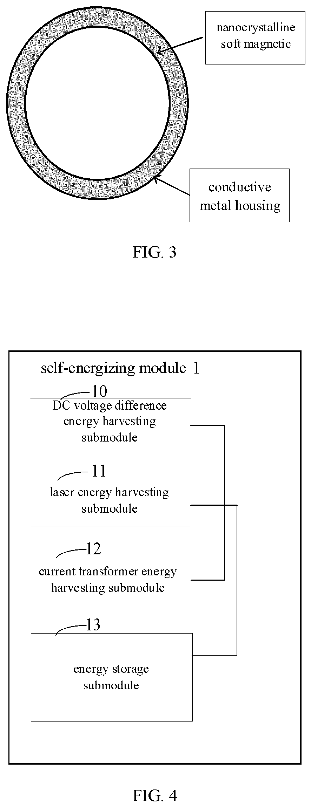

Further, as shown in FIG. 3, the shielding housing 4 includes a conductive metal outer layer, a nanocrystalline soft magnetic inner layer, and an equipotential module.

The shielding housing 4 is designed as a sleeve type to form a physical barrier, in order to effectively block the direct interference of the external electromagnetic field. The nanocrystalline soft magnetic material, as the material of the inner layer of the shielding housing, has excellent magnetic shielding performance, which can further absorb and weaken the residual magnetic field after penetrating the shielding housing, and reduce the impact of the magnetic field on the sensor. The nanocrystalline structure enables the material to have a higher magnetic conductivity and a better magnetic shielding effect. Equipotential technology refers to that a potential at each point inside the shielding housing is ensured to be equal through a special design. Accordingly, the electromagnetic interference caused by the potential difference is eliminated, and the accuracy and stability of the measurement of the sensor are improved. The equipotential module may include components such as an equipotential connector, an equipotential wire, etc., to implement potential equalization inside the shielding housing.

With the above-mentioned combined electromagnetic field shielding technology, a power-frequency electromagnetic protection performance in the embodiment is significantly improved to 80dB or more. Such performance level is two orders of magnitude higher than that in the existing technology, which means that the sensor can operate stably in a worse electromagnetic environment without being affected by external electromagnetic interference. Such combined electromagnetic field shielding technology provides a more reliable guarantee for the current measurement at the ultra-high voltage terminal, which can not only improve the measurement accuracy and stability of the sensor, but also prolong the service life of the sensor.

In an exemplary embodiment, as shown in FIG. 4, the self-energizing module 1 includes: a DC voltage difference energy harvesting submodule 10, a laser energy harvesting submodule 11, a current transformer energy harvesting submodule 12, and an energy storage submodule 13.

The DC voltage difference energy harvesting submodule 10 is configured to collect an electric energy on a DC transmission line in an environment in which the measured device is located.

The laser energy harvesting submodule 11 is configured to collect an optical energy generated by a laser device in an environment in which the measured device is located, and convert the generated optical energy into electric energy.

The current transformer energy harvesting submodule 12 is configured to collect a magnetic energy of a magnetic field generated by a substation and a conductor in the environment in which the measured device is located, and convert the magnetic energy of the magnetic field into electric energy.

The energy storage submodule 13 is connected to the DC voltage difference energy harvesting submodule, the laser energy harvesting submodule, and the current transformer energy harvesting submodule, and is configured to store the electric energies obtained by the DC voltage difference energy harvesting submodule, the laser energy harvesting submodule, and the current transformer energy harvesting submodule.

The DC voltage difference energy harvesting submodule 10 is specifically configured to collect the electric energy on the DC transmission line in the environment in which the measured device is located. In the DC transmission system, a slight voltage difference may exist between different points due to factors such as a line resistance, a contact resistance, etc. The DC voltage difference energy harvesting submodule uses the voltage difference to harvest the electric energy. By means of a special circuit design and energy conversion technology, the slight voltage difference on the DC transmission line can be converted into available electric energy, to provide continuous power support for the sensor.

The laser energy harvesting submodule 11 is configured to collect the optical energy generated by the laser device in the environment in which the measured device is located, and convert the laser energy into the electric energy. In some scenarios, the laser device emits a strong beam. The laser energy harvesting submodule includes a photoelectric conversion component, such as a photovoltaic cell, which can efficiently convert the received optical energy into the electric energy. Such a conversion process is based on the photoelectric effect, that is, when photons interact with matter, electrons can be excited, thereby generating the current.

The current transformer energy harvesting submodule 12 is configured to collect the magnetic energy of the magnetic field generated by the substation and the conductor in the environment in which the measured device is located, and convert the magnetic energy into the electric energy. In an electric power system, the current flows through a conductor to produce a surrounding magnetic field, which contains energy. The current transformer energy harvesting submodule converts the energy in the magnetic field into electric energy by using a special magnetoelectric conversion technology, such as the magnetic induction principle. Such a conversion process usually involves components such as a magnetic core, a winding, etc., which can sense changes in the magnetic field and generate corresponding currents.

Specifically, when determining that a current value corresponding to the magnetic energy of the magnetic field falls within a first current range, the current transformer energy harvesting submodule performs the energy harvesting in an intermittent energy harvesting mode. When determining that the current value corresponding to the magnetic energy of the magnetic field falls within a second current range, the current transformer energy harvesting submodule performs the energy harvesting in a continuous energy harvesting mode.

A maximum value of the first current range is less than a minimum value of the second current range.

It should be appreciated that when the current transformer energy harvesting submodule detects that the current value corresponding to the magnetic energy of the magnetic field falls within the first current range (the value in which is relatively small), the submodule may use the intermittent energy harvesting mode. In such mode, the energy harvesting process is not continuous, but is performed at a preset time interval. In such a manner, energy consumption can be reduced, and it can be ensured that the electric energy can be effectively collected in a case where a current is relatively small.

When the current value rises into the second current range (the value in which is greater than that in the first current range), the submodule is switched to the continuous energy harvesting mode. In this mode, the energy harvesting process is continuous to maximize the use of rich magnetic energy at the large current condition, and provide sufficient and stable electric energy for the sensor.

The first current range is set based on consideration of a small current condition in an actual application scenario, in order to ensure that sufficient electric energy can also be accumulated in the intermittent energy harvesting mode in a small current environment. Compared to the first current range, the second current range is set for a higher current condition, in order to make full use of the rich magnetic energy in these conditions to perform the continuous energy harvesting.

By means of dynamic adjustment of the energy harvesting mode, an intelligent energy harvesting strategy is implemented in the embodiment, which not only ensures effective energy harvesting in the small current condition, but also maximizes the collection of the electric energy in the large current condition. Flexible switching between the intermittent energy harvesting mode and the continuous energy harvesting mode helps reduce unnecessary energy loss and improve overall energy efficiency.

The energy storage submodule 13 is connected to the above-mentioned three energy harvesting submodules, and is configured to store the electric energy obtained by these energy harvesting submodules. Due to the instability and intermittency of the environmental energy, direct utilization of the energy may not satisfy the continuous power supply requirement of the sensor. The energy storage submodule typically includes an energy storage component, such as a battery or a supercapacitor, which can store the electric energy obtained from the energy harvesting submodules and release the electric energy to the sensor when needed. With a reasonable energy management strategy, the energy storage submodule ensures that the sensor can obtain a stable electric power supply under various environmental conditions.

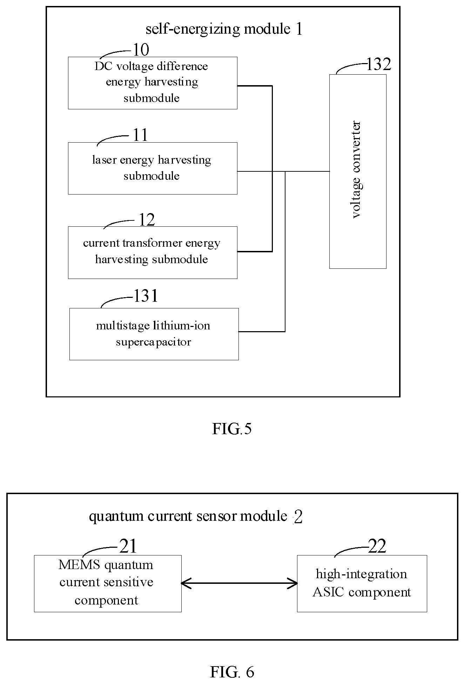

In an exemplary embodiment, as shown in FIG. 5, the energy storage submodule 13 includes a multistage lithium-ion supercapacitor 131 and a voltage converter 132.

The multistage lithium-ion supercapacitor is connected to the DC voltage difference energy harvesting submodule, the laser energy harvesting submodule, and the current transformer energy harvesting submodule, and is configured to store electric energy obtained by the DC voltage difference energy harvesting submodule, the laser energy harvesting submodule, and the current transformer energy harvesting submodule.

The voltage converter is configured to adjust an output voltage of the multistage lithium-ion supercapacitor according to the operating voltage of the quantum current sensor module.

It should be appreciated that the multistage lithium-ion supercapacitor is a core energy storage component of the energy storage submodule, and is responsible for storing electric energy obtained from different energy harvesting submodules (for example, the DC voltage difference energy harvesting submodule, the laser energy harvesting submodule, and the current transformer energy harvesting submodule). These energy harvesting submodules collect the environmental energy or energy in an operating process of a device through their respective modes (e.g., by using the DC voltage difference, the laser energy, and the electric energy induced by the current transformer), and convert the energy into electric energy to be stored in the multistage lithium-ion supercapacitor. The multistage lithium-ion supercapacitor has characteristics such as a high energy density, a long service life, and fast charge and discharge, etc., which can ensure that the quantum current sensor module can be provided with continuous and stable electric energy under complex and changeable operating conditions.

It should be appreciated that the voltage converter is a key adjustment component in the energy storage submodule, and is responsible for adjusting an output voltage of the multistage lithium-ion supercapacitor according to an operating voltage requirement of the quantum current sensor module. Since the quantum current sensor module has a specific requirement on the operating voltage, and the output voltage of the multistage lithium-ion supercapacitor may fluctuate as the stored electricity changes, precise voltage adjustment needs to be performed through the voltage converter. The voltage converter can ensure a stable output voltage that meets a requirement, and provide a high-quality electric power supply for the quantum current sensor module, thereby ensuring the normal operation and measurement accuracy of the the quantum current sensor module.

In an exemplary embodiment, the DC voltage difference energy harvesting submodule is constructed based on a DC transmission line voltage drop principle. The specific process includes that an equivalent low-voltage high-current model of the transmission line is established, and electricity generated on the high-voltage DC transmission line is collected by using an ultra-high gain boost converter solution.

The electric energy on the DC transmission line in the environment in which the measured device is located is obtained through the conversions of the magnetic energy, the electric energy or the optical energy. First, an actual DC transmission line is modeled, and is equivalent to a low-voltage high-current circuit model. The low-voltage high-current circuit model can reflect a relationship among the voltage, current, resistance and inductance of the transmission line. With the low-voltage high-current circuit model, the voltage drop in the transmission line and the electric energy contained therein can be more accurately analyzed and calculated. Subsequently, in order to efficiently collect the electric energy in the transmission line, a special circuit device is required, i.e., an ultra-high gain boost converter. The ultra-high gain boost converter has the capability to convert low-voltage electric energy into high-voltage electric energy, and has a very high boost ratio. In such a manner, even if the voltage drop in the transmission line is very small, the voltage can be converted into a relatively high voltage through the boost converter, thereby facilitating subsequent collection and utilization of the electric energy. Through the ultra-high gain boost converter, the low-voltage electric energy in the transmission line can be converted into the high-voltage electric energy and collected. The collected electric energy may be stored in the energy storage device (such as the multistage lithium-ion supercapacitor) for subsequent use.

In an exemplary embodiment, the laser energy harvesting submodule is based on a high-power high-beam-quality laser emission technology, a high-power laser shaping technology, uses a high-efficiency photoelectric conversion scheme to implement efficient energy transmission, and collects electricity generated on the laser.

Specifically, the laser energy harvesting submodule first emits laser beams through the high-power high-beam-quality laser. The laser beams are highly directional and centralized, and can be stably transmitted in air or in a particular medium. In a laser transmission process, the high-power laser shaping technology may perform precise shaping processing on a laser beam. When the shaped laser beam reaches a receiving terminal, the high-efficiency photoelectric conversion scheme starts to function. Specifically, an advanced photoelectric conversion material and technology are utilized to efficiently convert the optical energy in the laser beam into the electric energy. The electric energy is then collected and stored in the energy storage device (such as the multistage lithium-ion supercapacitor) for subsequent use.

In an exemplary embodiment, the current transformer (CT) energy harvesting submodule uses optocoupler automatic control and self-adaptive switching multiple voltage rectifier energy harvesting method to perform reliable electric energy harvesting at the small current and continuous electric energy harvesting at the large current, and collect electric energy generated in the magnetic field of the substation and the conductor.

The CT energy harvesting submodule converts an alternating magnetic field around the conductor into sensor electric energy based on the electromagnetic induction principle. With the optocoupler automatic control and the self-adaptive switching multiple voltage rectifier energy harvesting method, the reliable electric energy harvesting is performed at the small current, the continuous electric energy harvesting is performed at the large current, and the electric energy generated in the magnetic field of the substation and the conductor is collected.

Specifically, as a key component for isolating and transmitting a signal, an optocoupler can monitor a magnitude of a current in real time, and automatically adjust an energy harvesting strategy according to a variation of the current. When the current is relatively small, the optocoupler triggers a corresponding control circuit, so that the energy harvesting submodule operates in a low power consumption mode, to ensure the reliable electric energy harvesting under the small current condition.

A multi-voltage rectifier circuit is a circuit structure capable of efficiently boosting a voltage, and can convert a lower input voltage into a higher output voltage. The self-adaptive switching technology can automatically adjust the operating status of the multi-voltage rectifier circuit according to the magnitude of the current, to ensure that the electric energy harvesting can be performed continuously and stably under the large current condition. When the current increases, the self-adaptive switching technology may adjust a parameter of the multi-voltage rectifier circuit, so that the multi-voltage rectifier circuit can efficiently process a larger current, thereby continuously providing sufficient electric energy to the sensor.

When the current is small, a thyristor is disconnected, and the CT energy harvesting submodule supplies power to a load and an energy storage capacitor. The energy harvesting submodules are connected to the multistage lithium-ion supercapacitor and can charge the multistage lithium-ion supercapacitor.

In order to solve a voltage stability problem caused by a lithium-ion supercapacitor, a pulse width modulation (PWM) switch and a low-dropout regulator (LDO) technology are utilized to design a power supply voltage management scheme for the sensor. That is, the self-energizing module further includes a power supply management module, which can implement multi-voltage power supply of more than 20 channels with 1% accuracy under the power supply voltage range of 1.2V to 15V, and a power supply efficiency can reach 90% or more, thereby ensuring the stable operation of the quantum current sensor.

Specifically, the power supply management module uses a multi-power supply circuit for electric energy harvesting to implement integrated and efficient utilization of multiple sources such as the DC voltage difference, the laser, and the ultra-wide range CT, monitors and manages power generation capacities of the three energy harvesting modules and an electric quantity of a rechargeable battery, so that the electric energy of the energy harvesting module may be directly supplied to other modules of the sensor through a DC/DC converter, or a multistage lithium-ion supercapacitor is utilized to supply power. In addition, the charging condition of the battery is managed to prevent overcharging from damaging the battery.

There exists a trigger circuit on the bi-directional thyristor. The micro control unit (MCU) on the power control module may adjust a duty ratio of the output PWM according to the relationship among the electric energy required by the load, the harvested energy, and the stored energy, and dynamically control on-time of the bi-directional thyristor, so that the thyristor is turned on when the current is large, the CT energy harvesting submodule is short-circuited to discharge the energy, and the energy storage capacitor supplies power to the load.

In an embodiment, as shown in FIG. 6, the quantum current sensor module 2 includes a Micro-Electro-Mechanical System (MEMS) quantum current sensitive component 21 and a high-integration Application Specific Integrated Circuit (ASIC) component 22.

The quantum current sensor module integrates two important units, i.e., the MEMS quantum current sensitive component and the high-integration ASIC component. Such integrated design makes the module compact in size and low in power consumption, and is highly appropriate to applications where strict requirements are imposed on volume and energy consumption.

The MEMS quantum current sensitive component has a fiberless high-integration structure of "multi-wafer stacking + double stacking grating interference + microlens". Such structure breaks through the challenge of heterogeneous integration between a diamond and a silicon substrate, and implements the integration of six devices in a very small volume (such as 1cm³). Such highly integrated design not only reduces the volume of the component, but also improves the sensitivity and stability of the component. The fiberless design reduces external interferences and improves the measurement accuracy. The multi-wafer stacking and double stacking grating interference technologies enhance the degree of the sensitivity of the component to the current, so that the measurement is more accurate. The addition of microlens further optimizes the optical path and improves the transmission efficiency of the optical signal.

The high-integration ASIC component uses a high-complexity and multi-dimensional channel quantum current sensor closed-loop conditioning ASIC architecture. Such architecture implements simultaneous excitation of six-wave fine magnetic resonance energy levels, which enables the integration of ten functional modules in a very small volume (such as 0.1cm³). The multi-dimensional channel design enables the ASIC component to process multiple input signals simultaneously, thereby improving the processing speed and efficiency. The closed-loop conditioning architecture enhances the system stability and reliability, so that the measurement is more accurate and stable. The simultaneous excitation of the six-wave fine magnetic resonance energy levels further improves the accuracy and resolution of the measurement.

In the embodiment, the quantum current sensor module implements volume miniaturization and power consumption reduction by integrating the MEMS quantum current sensitive component and the high-integration ASIC component. The MEMS quantum current sensitive component adopts an innovative fiberless high-integration structure, and implements the integration of multiple components. The high-integration ASIC component implements high-integration and simultaneous excitation of multi-function modules through the complex architecture and the fine design. Such design not only improves the measurement accuracy and stability of the quantum current sensor module, but also provides broad application prospects for the quantum current sensor module in the scenarios of miniaturization and low power consumption.

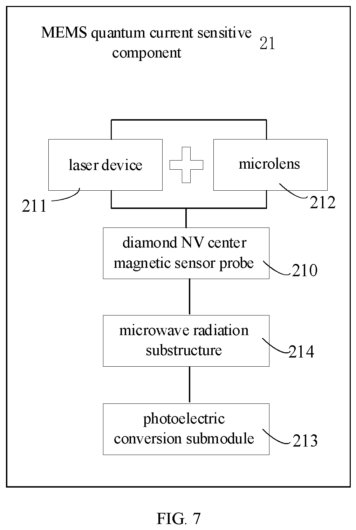

Optionally, as shown in FIG. 7, the MEMS quantum current sensitive component 21 includes a diamond nitrogen-vacancy (NV) center magnetic sensor probe 210, a laser device 211, a microlens 212, a microwave generation and analysis submodule, and a photoelectric conversion submodule 213.

The diamond NV center magnetic sensor probe 210 is configured to transmit a control instruction to the laser device when a magnetic field generated by the measured device is detected.

The laser device 211 is configured to generate a laser beam according to the control instruction.

The microlens 212 is configured to converge a laser beam onto the diamond NV center magnetic sensor probe, to excite the diamond NV center magnetic sensor probe to generate a fluorescence signal.

The photoelectric conversion submodule 213 is connected to the laser device and the diamond NV center magnetic sensor probe, and is configured to convert a reference laser beam emitted by the laser device and the fluorescence signal into a current signal of the measured device.

The microwave generation and analysis submodule is connected to the diamond NV center magnetic sensor probe and the photoelectric conversion submodule, and is configured to transmit an original microwave signal to the diamond NV center magnetic sensor probe, to allow the diamond NV center magnetic sensor probe to return a feedback microwave signal corresponding to the original microwave signal. The microwave generation and analysis submodule is further configured to determine, according to the feedback microwave signal and the current signal output by the photoelectric conversion submodule, magnetic field information of the magnetic field generated by the measured device.

The MEMS quantum current sensitive component 21 may further include a microwave radiation substructure 214. The microwave radiation substructure is connected to the microwave generation and analysis submodule, and optimizes a grounding plate and an impedance transformation structure through an impedance matching design technology, and accordingly, the transmission loss and reflection of the original microwave signal are reduced.

Optionally, the diamond NV center magnetic sensor probe is a key member of the MEMS quantum current sensitive component, and the diamond NV center detects a magnetic field by using the NV center in the diamond. The NV center refers to a special diamond defect state, which is formed by replacing two C12 atoms with one nitrogen atom and one vacancy V which appear in pairs. The accuracy and minimum detection limit of the magnetic field measurement are closely related to indicators such as concentration of NV centers and decoherence time in the diamond, etc. A high concentration of NV centers can improve the sensitivity of the measurement, and a long decoherent time helps maintain the stability of the measurement. As a natural quantum sensor, the NV center is highly stable and highly sensitive to the magnetic field, which allows the NV center to have a unique application value in the field of magnetic field measurement.

The manufacturing of the diamond NV center is a complex and refined process, which mainly includes following two steps.

Step I: manufacturing of a diamond material, including: equipment growth with microwave plasma chemical vapor deposition method (MPCVD), during which the equipment is capable of providing a stable growth environment; impurity suppression, during which a cyclic quartz glass design effectively suppresses the production of impurities during the diamond growth and ensures the purity of the diamond; plasma control, during which a controllable uniform plasma technology is used, the uniformity of the diamond growth is improved, so that a high purity diamond with a purity of more than 99.99% is manufactured; nitrogen atom doping, during which about 1-10ppm nitrogen atoms are doped simultaneously during the diamond growth, which is the basis for forming the NV center.

Step II: manufacutirng of a diamond NV center, including: electron irradiation and high temperature annealing, during which a nitrogen atom in the diamond is converted into an NV center through the electron irradiation based on the diamond substrate, and then the high temperature annealing is performed to stabilize the structure of the NV center; in situ annealing technology, in which the electron irradiation in situ annealing technology is utilized to implement the process of irradiation and annealing simultaneously, the original two sets of equipment are integrated into one set, which greatly improves the conversion rate of the NV color center (from 20% to 50%).

In view of this, the diamond NV center magnetic sensor probe, as the core member of the MEMS quantum current sensitive component, can manufacture the NV center having extremely high sensitivity and stability in the magnetic field measurement, which provides a solid guarantee for the performance of the quantum current sensor.

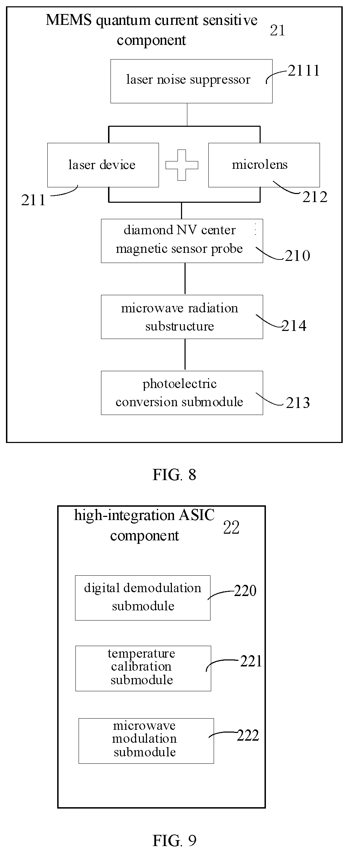

In an exemplary embodiment, as shown in FIG. 8, the laser device includes a laser 2110 and a laser noise suppressor 2111. The laser is configured to generate a laser beam according to a control instruction. The laser noise suppressor is configured to suppress a power noise generated by the laser during an operation thereof.

It should be appreciated that the laser noise suppressor is mainly configured to suppress the power noise of the laser and improve magnetic detection sensitivity. The laser is mainly configured to initialize a quantum state of diamond ensemble NV centers. The laser is responsible for generating precisely controlled laser beams according to an external input control instruction. These laser beams have many applications in the field of quantum technology, for example, in the embodiment these laser beams are specifically used for the initialization of the quantum state of the diamond ensemble NV centers. The NV center serves as a popular candidate for a quantum bit, the precise initialization of the quantum states thereof is the foundation for implementing applications such as quantum computing and quantum sensing, etc.

It should be appreciated that a core task of the laser noise suppressor is to suppress the power noises inevitably generated by the laser in the operating process thereof. These noises may interfere with the initialization process of the quantum state, and then reduce the sensitivity of the magnetic detection. By effectively suppressing these noises, the laser noise suppressors play a key role in improving the magnetic detection performance of the entire system. The laser noise suppressor may use multiple technical means to suppress the noise, such as an active noise control, passive noise isolation, and optical filtering. The combined application of these technologies can significantly reduce the noise components in the laser output, thereby improving the purity and stability of the laser beam.

In the embodiment, in high-precision applications such as the quantum sensing and quantum computing, any tiny noise may have a significant impact on an experimental result. Accordingly, the introduction of the laser noise suppressor is essential to improve overall performance and magnetic detection sensitivity of the system. The cooperative operation of the laser and the laser noise suppressor enables the laser device 211 to meet both high power output and low noise level requirements.

In an exemplary embodiment, the microlens 212, through optical characteristics thereof, converges the laser beams generated by the laser. By accurately adjusting a focal length and a position of the microlens, it can be ensured that the laser beam is irradiated on the diamond NV center magnetic sensor probe with a minimum spot size and a maximum energy density. When the laser beams converge and are irradiated on the diamond NV center, electrons in the NV center are excited from a ground state to an excited state. The electrons in the excited state then spontaneously return to the ground state and release a fluorescence signal. The precise convergence effect of the microlens 212 ensures that the laser beams can effectively excite the NV center to generate the fluorescence signal, which provides a basis for subsequent magnetic sensing measurement.

Through the convergence effect of the microlens 212 on the laser beams, the coupling efficiency between the laser beams and the diamond NV center magnetic sensor probe can be significantly improved, so that the intensity of the fluorescence signal is enhanced, which not only helps improve the signal-to-noise ratio of the magnetic sensor measurement, but further improves the measurement precision and sensitivity.

In an exemplary embodiment, the photoelectric conversion submodule 213 is capable of receiving a reference laser beam from the laser device and the fluorescence signal generated by the diamond NV center magnetic sensor probe. The fluorescence signal carries important information about the measured magnetic field or current. A core function of the submodule is to convert a received optical signal (the reference laser beam and the fluorescent signal) into an electrical signal. Such a process usually involves the use of photoelectric effects or photoelectric conversion materials, ensuring that the optical signals can be efficiently converted into electrical signals that can be processed and analyzed by a subsequent circuit. The converted electrical signals are output in the form of currents, and these electrical signals are directly related to the state of the measured device (such as a magnetic field source or a current source). By measuring and analyzing these current signals, key parameters of the measured device can be deduced, such as a magnetic field intensity, a magnetic field direction, or a current magnitude, etc.

In an exemplary embodiment, a primary task of the microwave generation and analysis submodule is to generate an original microwave signal and transmit the original microwave signal accurately to the diamond NV center magnetic sensor probe. The diamond NV center magnetic sensor sensor is capable of responding to the received microwave signal due to the unique physical characteristic. The response is closely related to the state of the magnetic field of the environment where the probe is located. After receiving the microwave signal, the diamond NV center magnetic sensor probe modulates the original microwave signal according to the state of the magnetic field where the diamond NV center magnetic sensor probe is located, generates a feedback microwave signal, and transmits the feedback microwave signal back to the microwave generation and analysis submodule. The feedback microwave signal contains key information about the magnetic field generated by the measured device. After receiving the feedback microwave signal, the microwave generation and analysis submodule performs detailed processing and analysis on the feedback microwave signal by using a built-in high-precision analysis circuit. In addition, the submodule further combines a current signal output by the photoelectric conversion submodule. The current signal also contains information related to the magnetic field, and the current signal is obtained by converting photocurrent generated by the diamond NV center magnetic sensor probe under an illumination. By combining the above two types of signals, the microwave generation and analysis submodule can accurately analyze the detailed information of the magnetic field generated by the measured device, such as the magnetic field intensity, the magnetic field direction, etc.

In an embodiment, FIG. 9 is a schematic structure diagram of a high-integration ASIC component 22 that includes a digital demodulation submodule 220, a temperature calibration submodule 221, and a microwave modulation submodule 222.

The digital demodulation submodule 220 is mainly configured to receive and rapidly demodulate a fluorescence signal in the quantum current sensitive component, implement frequency tracking and identification of the fluorescence signal, and generate a digital rapid agile signal. A demodulation speed directly affects a measurement speed of the MEMS quantum current sensitive component. The microwave modulation submodule is mainly configured to excite a microwave signal in the MEMS quantum current sensitive component, and directly determines a measurement range, a precision, and a speed of magnetic field measurement.

The temperature calibration submodule 221 is mainly configured to suppress a temperature drift of the ASIC circuit body, in order to ensure a high reliability operation of the ASIC circuit in a wide temperature range environment.

It should be appreciated that a primary task of the temperature calibration submodule 221 is to suppress a temperature drift generated by the ASIC circuit body due to a temperature change. The temperature drift refers to an offset of a circuit parameter (such as a voltage, a current, a resistance or a capacitance) as the temperature changes. The offset may affect the performance and precision of the circuit.

Specifically, the temperature calibration submodule first needs to monitor the operating temperature of the ASIC circuit in real time, which is generally achieved by a built-in temperature sensor capable of sensing a temperature change around the circuit and converting the temperature change into an electrical signal. According to the monitored temperature information, the temperature calibration submodule generates a corresponding calibration signal or an adjustment parameter to compensate for the offset of the circuit parameter due to the temperature change. Such calibration may involve adjustments to a gain, a frequency response, or a threshold voltage of a key component such as an amplifier, a filter, a comparator, etc., in the circuit. The calibration signal or adjustment parameter may be fed back to a relevant portion of the ASIC circuit to correct an error caused by the temperature change in real time. Such feedback control mechanism ensures that the circuit can maintain stable performance and precision in the wide temperature range environment. The continuous operation of the temperature calibration submodule enables the ASIC circuit to maintain the high reliability operation under an extreme temperature condition, such as a high temperature or a low temperature environment, which is particularly important for electronic devices needing to operate in a severe environment, such as outdoor communication devices, industrial control systems, etc.

Further, the diamond NV center magnetic sensor probe includes a diamond NV center and a microwave transmission antenna. The microwave modulation submodule 222 is configured to generate a microwave modulation submodule signal, and transmit the microwave modulation submodule signal to the diamond NV center through the microwave transmission antenna, to control a manipulation consistency of the diamond ensemble NV centers through the microwave modulation submodule signal.

It should be appreciated that the diamond NV center, as a core component of the magnetic sensor, is extremely sensitive to changes in the magnetic field due to a unique quantum property of the diamond NV center. The diamond NV center can convert the magnetic field information into a measurable quantum state change, and is a key element in the quantum magnetic sensing technology. It should be appreciated that the microwave transmission antenna is responsible for efficiently transmitting an external microwave signal to the diamond NV center, so that the microwave transmission antenna serves as a bridge to ensure that the microwave signal can interact with the NV center accurately, and thus the accurate measurement of the magnetic field can be implemented.

When the external magnetic field changes, the quantum state of the diamond NV center changes accordingly. The microwave signal applied through the microwave transmission antenna may interact with the NV center, and then the information of the external magnetic field is inferred by measuring a signal change after the interaction. The microwave modulation submodule is a key part of the quantum current sensor module, and is responsible for generating accurate and controllable microwave modulation submodule signals. These signals have a specific frequency, amplitude and phase, which is an important means to manipulate the consistency of the diamond ensemble NV centers. The microwave modulation submodule signal is transmitted to the diamond NV center through the microwave transmission antenna. These signals can accurately manipulate the quantum state of the NV center to ensure the consistency of the behavior of each NV center in the diamond ensemble, which is essential to improve the accuracy and stability of the magnetic sensor.

In the embodiment, the temperature calibration submodule is configured to suppress the temperature drift of the microwave modulation submodule.

It should be appreciated that the core task of the temperature calibration submodule is to ensure that the microwave modulation submodule is capable of maintaining stable performance under various temperature conditions. An electronic device may generate heat when operating, which may cause a temperature change in the operating environment. The temperature change may cause a slight change in circuit parameters inside the microwave modulation submodule, thereby affecting the operating performance and the accuracy of the output signal. Such a phenomenon is referred to as the temperature drift. In order to effectively address this problem, the temperature calibration submodule is integrated into the system. The temperature calibration submodule first monitors the operating temperature of the microwave modulation submodule in real time through a high-precision temperature sensor. Once a temperature change is detected, the temperature calibration submodule responds quickly to generate a corresponding calibration signal or adjustment parameter. The calibration signal or adjustment parameter is then applied to the microwave modulation submodule to correct in real time the offset of the circuit parameter caused by the temperature change. Through the dynamic calibration process, the temperature calibration submodule can significantly suppress the temperature drift of the microwave modulation submodule, in order to ensure that the temperature calibration submodule is capable of maintaining the high precision and stability in the wide temperature range environment.

In the embodiment, the high-integration ASIC component successfully constructs a high-complexity quantum current sensor ASIC system architecture based on an advanced CMOS process. The architecture not only integrates the high-difficulty circuits such as the microwave conditioning submodule, the digital demodulation submodule, and the temperature self-compensation circuit, etc., but also implements the high-integration of the three functional modules within an extremely compact space of 0.1cm³, and forms a fully closed-loop tight connection with the detector sensitive componenet.

In terms of signal conditioning, the ASIC component can be configured with advanced ASIC technologies such as up-and-down sideband broadband frequency conversion and orthogonal mixing technologies, which implements free adjustment of double sideband large bandwidth centered on a single frequency point, thereby effectively expanding the bandwidth and achieving a doubling effect. In addition, the component further integrates a high-complexity circuit in a GHz-level frequency modulation range such as a local oscillator signal, a high-performance microwave signal, etc., and combines an orthogonal mixing structure with a higher-order network matching technology. Accordingly, an image rejection ratio of a mixer is significantly improved, and the accuracy and stability of the signal processing are further improved.

In terms of temperature self-compensation, the high-integration ASIC component adopts the innovative on-chip modulation signal monitoring technology. In combination with a mapping relationship between a temperature and a radio frequency (RF) key circuit performance index, the high-integration ASIC component dynamically adjusts the state and the offset of the RF circuit, and ensures the stable operation of the ASIC component in the wide temperature range environment. This technology not only improves the adaptability of the component, but also provides a strong guarantee for the reliable operation of the component in a harsh environment.

In terms of demodulation and signal generation, the ASIC component is truly unique. The ASIC component adopts the advanced scheme of "digital demodulation + agile source signal fast generation +DAC fast establishment". Based on the principle of numerical control oscillator, digital technologies such as an accumulator, a mapping module, and a phase amplitude mapper, etc., are ingeniously utilized to implement the fast and accurate generation of digital signals in a large frequency modulation range. In addition, by developing a phase-locked loop circuit noise suppression technology based on a time domain amplification theory, the component can amplify an input time error, thereby improving a phase-locked loop loop gain and a phase noise performance.

The aforementioned MEMS quantum current sensitive component integrates six core devices including a diamond NV center magnetic sensor probe, a microwave transmission antenna, a microwave modulation submodule, and the like in an extremely small space (such as 1cm³). Such highly integrated design not only reduces the volume of the component, but also improves the reliability and stability of the component. Compared to the conventional quantum magnetic sensing technology, the MEMS quantum current sensitive component in the embodiment uses a fiberless design, which makes the component more structurally simple and avoids extra complexity and cost of the optical fiber. In addition, the fiberless design helps to improve the adaptability and flexibility of the component, so that the component can be widely applied in various environments.

The operating principle of the above-mentioned non-intrusive passive wireless self-energizing quantum current sensor is outlined as follows. The operating principle of the non-intrusive passive wireless self-energizing quantum current sensor is ingenious and highly efficient. The sensor collects multi-source energy efficiently through three energy harvesting modules, i.e., the DC voltage difference energy harvesting submodule, the laser energy harvesting submodule, and the ultra-wide-range current transformer (CT) energy harvesting submodule.

The DC voltage difference energy harvesting submodule uses the voltage difference between different points on the high-voltage DC transmission line, and collects electric energy by setting energy harvesting points. The energy harvesting power is up to 1.2W, which provides a stable electric energy basis for the sensor. In addition, the laser energy harvesting submodule focuses on collecting electric energy generated on the laser and adds another important energy source to the sensor. The ultra-wide-range CT energy harvesting submodule further enhances the energy storage of the sensor with an energy harvesting power of 0.8W by capturing electric energy in the substation and the conductor magnetic field.

In order to ensure the efficient utilization of these energies, the sensor is provided with a built-in power management module. The power management module is not only responsible for monitoring and managing the electricity generation capacities of the three energy harvesting modules, but also monitors the state of the electric quantity of the multistage lithium-ion supercapacitor. When the energy is sufficient, the power management module may directly supply power to other modules of the sensor through the DC/DC converter. When the energy is insufficient, the power management module may automatically switch to the multistage lithium-ion supercapacitor to supply power, in order to ensure that the comprehensive energy harvesting power of the sensor is not less than 2W in the AC/DC scenario, and fully meet the electric energy requirement of the sensor. The sensor also adopts the cooperation of the supercapacitor and the self-energizing technology. Such design not only ensures the smooth supply of energy, but also allows the storage of the excess electricity when there is an excess of energy. Even in the emergency situation of power grid failure and power outage, the laser energy harvesting submodule can be activated promptly to ensure that the sensor can continue to operate without being disturbed by external factors.

In terms of the current measurement, the sensor uses a high-integration, fiberless MEMS quantum current sensitive component to perform the initial measurement. The high-integration ASIC component performs fine conditioning on the MEMS quantum current sensitive component through three functional modules, i.e., the digital demodulation submodule, the temperature calibration submodule, and the microwave modulation submodule. Such design not only greatly improves the range, accuracy, bandwidth, and power consumption performance of the sensor, but also implements the current measurement target of wide range, high precision, wideband, and low power consumption.

Finally, all collected and processed data are exchanged with other terminals through a wireless communication module, which provides strong technical support for monitoring and management of the electric power system. Accordingly, the non-intrusive passive wireless self-energizing quantum current sensor, with its unique operating principle and outstanding performance, becomes an indispensable and important component in the electric power system.

The technical features in the aforementioned embodiments may be combined in any manner. In order to make the description brief, all possible combinations of the technical features in the aforementioned embodiments are not described. However, as long as there is no contradiction between the combinations of the technical features, these combinations should be considered as the scope of the present invention.

The above-described embodiments only express several implementation modes of the present invention, and the descriptions are relatively specific and detailed, but should not be construed as limiting the scope of the present invention. It should be noted that, those of ordinary skill in the art can make several transformations and improvements without departing from the concept of the present invention, and these all fall within the protection scope of the present invention. Therefore, the protection scope of the present invention should be subject to the appended claims.

## Claims

1. A non-intrusive passive wireless self-energizing quantum current sensor comprising a self-energizing module and a quantum current sensor module, wherein
the self-energizing module is configured to collect environmental energy of an environment in which a measured device is located, and convert the environmental energy into electric energy, to supply power to the quantum current sensor module with the converted electric energy, wherein the environmental energy comprises at least one of electric energy, optical energy, or magnetic energy; and
the quantum current sensor module is configured to sense a current signal of the measured device when it is detected that the measured device generates a magnetic field.

2. The non-intrusive passive wireless self-energizing quantum current sensor according to claim 1, wherein the quantum current sensor module comprises a diamond nitrogen-vacancy, NV, center magnetic sensor probe, a laser device, a microlens, and a photoelectric conversion submodule;
the diamond NV center magnetic sensor probe is configured to transmit a control instruction to the laser device when a magnetic field generated by the measured device is detected;
the laser device is configured to generate a laser beam according to the control instruction;
the microlens is configured to converge a laser beam onto the diamond NV center magnetic sensor probe, to excite the diamond NV center magnetic sensor probe to generate a fluorescence signal; and
the photoelectric conversion submodule is connected to the laser device and the diamond NV center magnetic sensor probe, and is configured to convert a reference laser beam emitted by the laser device and the fluorescence signal into a current signal of the measured device.

3. The non-intrusive passive wireless self-energizing quantum current sensor according to claim 2, wherein the self-energizing module comprises:
a direct current, DC, voltage difference energy harvesting submodule, configured to collect electric energy on a DC transmission line in the environment in which the measured device is located;
a laser energy harvesting submodule, configured to collect optical energy generated by the laser device in the environment in which the measured device is located, and convert the generated optical energy into electric energy;
a current transformer energy harvesting submodule, configured to collect magnetic energy of a magnetic field generated by a substation and a conductor in the environment in which the measured device is located, and convert the magnetic energy of the magnetic field into electric energy; and
an energy storage submodule, connected to the DC voltage difference energy harvesting submodule, the laser energy harvesting submodule, and the current transformer energy harvesting submodule, and configured to store the electric energy obtained by the DC voltage difference energy harvesting submodule, the laser energy harvesting submodule, and the current transformer energy harvesting submodule.

4. The non-intrusive passive wireless self-energizing quantum current sensor according to claim 3, wherein
the current transformer energy harvesting submodule is configured to, when determining that a current value corresponding to the magnetic energy of the magnetic field falls within a first current range, perform energy harvesting in an intermittent energy harvesting mode;
the current transformer energy harvesting submodule is configured to, when determining that the current value corresponding to the magnetic energy of the magnetic field falls within a second current range, perform the energy harvesting in a continuous energy harvesting mode; and
wherein a maximum value of the first current range is less than a minimum value of the second current range.

5. The non-intrusive passive wireless self-energizing quantum current sensor according to claim 3, wherein the energy storage submodule comprises:
a multistage lithium-ion supercapacitor, connected to the DC voltage difference energy harvesting submodule, the laser energy harvesting submodule, and the current transformer energy harvesting submodule, and configured to store the electric energy obtained by the DC voltage difference energy harvesting submodule, the laser energy harvesting submodule, and the current transformer energy harvesting submodule.

6. The non-intrusive passive wireless self-energizing quantum current sensor according to claim 2, wherein the the laser device comprises:
a laser, configured to generate the laser beam according to the control instruction; and
a laser noise suppressor, configured to suppress a power noise generated by the laser during an operation of the laser.

7. The non-intrusive passive wireless self-energizing quantum current sensor according to claim 2, wherein the quantum current sensor module further comprises:
a microwave generation and analysis submodule, connected to the diamond NV center magnetic sensor probe and the photoelectric conversion submodule, and configured to transmit an original microwave signal to the diamond NV center magnetic sensor probe, to allow the diamond NV center magnetic sensor probe to return a feedback microwave signal corresponding to the original microwave signal, and further configured to determine, according to the feedback microwave signal and a current signal output by the photoelectric conversion submodule, magnetic field information of the magnetic field generated by the measured device; and
a microwave radiation substructure, connected to the microwave generation and analysis submodule, and configured to reduce a transmission loss and a reflection of the original microwave signal.

8. The non-intrusive passive wireless self-energizing quantum current sensor according to claim 2, wherein the diamond NV center magnetic sensor probe comprises a diamond NV center and a microwave transmission antenna, the quantum current sensor module further comprises a microwave modulation submodule configured to generate a microwave modulation submodule signal, and transmit the microwave modulation submodule signal to the diamond NV center through the microwave transmission antenna, to control a manipulation consistency of diamond ensemble NV centers through the microwave modulation submodule signal.

9. The non-intrusive passive wireless self-energizing quantum current sensor according to claim 8, wherein the quantum current sensor module further comprises a temperature calibration submodule configured to suppress a temperature drift of the microwave modulation submodule.

10. The non-intrusive passive wireless self-energizing quantum current sensor according to claim 1, further comprising a shielding housing, wherein the self-energizing module and the quantum current sensor module are located within a cavity of the shielding housing.

11. The non-intrusive passive wireless self-energizing quantum current sensor according to claim 10, wherein the shielding housing comprises a conductive metal outer layer, a nanocrystalline soft magnetic inner layer, and an equipotential module.

12. The non-intrusive passive wireless self-energizing quantum current sensor according to claim 3, wherein the electric energy on the DC transmission line in the environment in which the measured device is located is obtained by converting the magnetic energy, the electric energy, or the optical energy.

13. The non-intrusive passive wireless self-energizing quantum current sensor according to claim 3, wherein the DC voltage difference energy harvesting submodule is constructed based on a DC transmission line voltage drop principle.

14. The non-intrusive passive wireless self-energizing quantum current sensor according to claim 5, wherein the energy storage submodule further comprises a voltage converter configured to adjust an output voltage of the multistage lithium-ion supercapacitor according to an operating voltage of the quantum current sensor module.

## Amended claims

### Amended claims in accordance with Rule 137(2) EPC.

1. A non-intrusive passive wireless self-energizing quantum current sensor comprising a self-energizing module (1) and a quantum current sensor module (2), wherein
the self-energizing module (1) is configured to collect environmental energy of an environment in which a measured device is located, and convert the environmental energy into electric energy, to supply power to the quantum current sensor module with the converted electric energy, wherein the environmental energy comprises at least one of electric energy, optical energy, or magnetic energy; and
the quantum current sensor module (2) is configured to sense a current signal of the measured device when it is detected that the measured device generates a magnetic field;
wherein the quantum current sensor module (2) comprises a diamond nitrogen-vacancy, NV, center magnetic sensor probe (210), a laser device (211), a microlens (212), and a photoelectric conversion submodule (213); wherein
the diamond NV center magnetic sensor probe (210) is configured to transmit a control instruction to the laser device (211) when a magnetic field generated by the measured device is detected;
the laser device (211) is configured to generate a laser beam according to the control instruction;
the microlens (212) is configured to converge a laser beam onto the diamond NV center magnetic sensor probe (210), to excite the diamond NV center magnetic sensor probe (210) to generate a fluorescence signal; and
the photoelectric conversion submodule (213) is connected to the laser device (211) and the diamond NV center magnetic sensor probe (210), and is configured to convert a reference laser beam emitted by the laser device (211) and the fluorescence signal into a current signal of the measured device;
**characterized in that** the self-energizing module (1) comprises:
a direct current, DC, voltage difference energy harvesting submodule (10), configured to collect electric energy on a DC transmission line in the environment in which the measured device is located;
a laser energy harvesting submodule (11), configured to collect optical energy generated by the laser device in the environment in which the measured device is located, and convert the generated optical energy into electric energy;
a current transformer energy harvesting submodule (12), configured to collect magnetic energy of a magnetic field generated by a substation and a conductor in the environment in which the measured device is located, and convert the magnetic energy of the magnetic field into electric energy; and
an energy storage submodule (13), connected to the DC voltage difference energy harvesting submodule (10), the laser energy harvesting submodule (11), and the current transformer energy harvesting submodule (12), and configured to store the electric energy obtained by the DC voltage difference energy harvesting submodule (10), the laser energy harvesting submodule (11), and the current transformer energy harvesting submodule (12).

2. The non-intrusive passive wireless self-energizing quantum current sensor according to claim 1, wherein
the current transformer energy harvesting submodule (12) is configured to, when determining that a current value corresponding to the magnetic energy of the magnetic field falls within a first current range, perform energy harvesting in an intermittent energy harvesting mode;
the current transformer energy harvesting submodule (12) is configured to, when determining that the current value corresponding to the magnetic energy of the magnetic field falls within a second current range, perform the energy harvesting in a continuous energy harvesting mode; and
wherein a maximum value of the first current range is less than a minimum value of the second current range.

3. The non-intrusive passive wireless self-energizing quantum current sensor according to claim 1, wherein the energy storage submodule (13) comprises:
a multistage lithium-ion supercapacitor (131), connected to the DC voltage difference energy harvesting submodule (10), the laser energy harvesting submodule (11), and the current transformer energy harvesting submodule (12), and configured to store the electric energy obtained by the DC voltage difference energy harvesting submodule (10), the laser energy harvesting submodule (11), and the current transformer energy harvesting submodule (12).

4. The non-intrusive passive wireless self-energizing quantum current sensor according to claim 1, wherein the the laser device comprises:
a laser, configured to generate the laser beam according to the control instruction; and
a laser noise suppressor, configured to suppress a power noise generated by the laser during an operation of the laser.

5. The non-intrusive passive wireless self-energizing quantum current sensor according to claim 1, wherein the quantum current sensor module (2) further comprises:
a microwave generation and analysis submodule, connected to the diamond NV center magnetic sensor probe (210) and the photoelectric conversion submodule (213), and configured to transmit an original microwave signal to the diamond NV center magnetic sensor probe (210), to allow the diamond NV center magnetic sensor probe (210) to return a feedback microwave signal corresponding to the original microwave signal, and further configured to determine, according to the feedback microwave signal and a current signal output by the photoelectric conversion submodule (213), magnetic field information of the magnetic field generated by the measured device; and
a microwave radiation substructure (214), connected to the microwave generation and analysis submodule, and configured to reduce a transmission loss and a reflection of the original microwave signal.

6. The non-intrusive passive wireless self-energizing quantum current sensor according to claim 1, wherein the diamond NV center magnetic sensor probe (210) comprises a diamond NV center and a microwave transmission antenna, the quantum current sensor module (2) further comprises a microwave modulation submodule configured to generate a microwave modulation submodule signal, and transmit the microwave modulation submodule signal to the diamond NV center through the microwave transmission antenna, to control a manipulation consistency of diamond ensemble NV centers through the microwave modulation submodule signal.

7. The non-intrusive passive wireless self-energizing quantum current sensor according to claim 6, wherein the quantum current sensor module (2) further comprises a temperature calibration submodule configured to suppress a temperature drift of the microwave modulation submodule.

8. The non-intrusive passive wireless self-energizing quantum current sensor according to claim 1, further comprising a shielding housing (4), wherein the self-energizing module (1) and the quantum current sensor module (2) are located within a cavity of the shielding housing (4).

9. The non-intrusive passive wireless self-energizing quantum current sensor according to claim 8, wherein the shielding housing (4) comprises a conductive metal outer layer, a nanocrystalline soft magnetic inner layer, and an equipotential module.

10. The non-intrusive passive wireless self-energizing quantum current sensor according to claim 1, wherein the electric energy on the DC transmission line in the environment in which the measured device is located is obtained by converting the magnetic energy, the electric energy, or the optical energy.

11. The non-intrusive passive wireless self-energizing quantum current sensor according to claim 1, wherein the DC voltage difference energy harvesting submodule (10) is constructed based on a DC transmission line voltage drop principle.

12. The non-intrusive passive wireless self-energizing quantum current sensor according to claim 3, wherein the energy storage submodule (13) further comprises a voltage converter (132) configured to adjust an output voltage of the multistage lithium-ion supercapacitor (131) according to an operating voltage of the quantum current sensor module (2).
